# EUROPÄISCHE PATENTSCHRIFT

(11) **EP 2 311 168 B1**
(45) Veröffentlichungstag und Bekanntmachung des Hinweises auf die Patenterteilung: **19.11.2014**
(21) Anmeldenummer: 09781534.4
(22) Anmeldetag: 06.08.2009
(51) Int. Cl.: H02J 7/00, G01R 31/36

(54) **VERFAHREN ZUR ÜBERWACHUNG DER RESTSTANDZEIT EINER BATTERIE**
METHOD FOR MONITORING THE REMAINING LIFE OF A BATTERY
PROCÉDÉ DE SURVEILLANCE DE L'AUTONOMIE RESTANTE D'UNE BATTERIE

(30) Priorität: 11.08.2008 DE 102008037193
(43) Veröffentlichungstag der Anmeldung: 20.04.2011
(73) Patentinhaber: Endress + Hauser Process Solutions AG, 4153 Reinach BL (CH)
(72) Erfinder: LAIBLE, Ingo, CH-4144 Arlesheim (CH); PROBST, Stefan, 79576 Weil am Rhein (DE); SEILER, Christian, 79424 Auggen (DE); THOREN, Werner, 79585 Steinen (DE)
(74) Vertreter: Andres, Angelika Maria
(86) Internationale Anmeldenummer: PCT/EP2009/060176
(87) Internationale Veröffentlichungsnummer: WO 2010/018116

(56) Entgegenhaltungen:
- US-A- 5 372 898
- US-A1- 2004 090 207
- US-A1- 2005 070 073

## Beschreibung

Die Erfindung betrifft ein Verfahren zur Überwachung der Reststandzeit einer Batterie, die zum Betreiben eines Feldgeräts in der Automatisierungstechnik verwendet wird.

In der Prozessautomatisierungstechnik werden vielfach Feldgeräte eingesetzt, die zur Erfassung und/oder Beeinflussung von Prozessgrößen dienen. Zur Erfassung von Prozessgrößen dienen Sensoren, wie beispielsweise Füllstandsmessgeräte, Durchflussmessgeräte, Druck- und Temperaturmessgeräte, pH-Redoxpotentialmessgeräte, Leitfähigkeitsmessgeräte, etc., welche die entsprechenden Prozessvariablen Füllstand, Durchfluss, Druck, Temperatur, pH-Wert bzw. Leitfähigkeit erfassen. Zur Beeinflussung von Prozessgrößen dienen Aktoren, wie zum Beispiel Ventile oder Pumpen, über die der Durchfluss einer Flüssigkeit in einem Rohrleitungsabschnitt bzw. der Füllstand in einem Behälter geändert werden kann. Als Feldgeräte werden im Prinzip alle Geräte bezeichnet, die prozessnah eingesetzt werden und die prozessrelevante Informationen liefern oder verarbeiten. Neben den zuvor genannten Sensoren und Aktoren werden als Feldgeräte allgemein auch solche Einheiten bezeichnet, die direkt an einem Feldbus angeschlossen sind und zur Kommunikation mit den übergeordneten Einheiten dienen, wie z.B. Remote I/Os, Gateways, Linking Devices und Wireless Adapters. Eine Vielzahl solcher Feldgeräte wird von der Endress + Hauser-Gruppe hergestellt und vertrieben.

In modernen Industrieanlagen sind Feldgeräte in der Regel über Bussysteme (Profibus®, Foundation® Fieldbus, HART®, etc.) mit übergeordneten Einheiten verbunden. Normalerweise handelt es sich bei den übergeordneten Einheiten um Leitsysteme bzw. Steuereinheiten, wie beispielsweise eine SPS (speicherprogrammierbare Steuerung) oder eine PLC (Programmable Logic Controller). Die übergeordneten Einheiten dienen unter anderem zur Prozesssteuerung, Prozessvisualisierung, Prozessüberwachung sowie zur Inbetriebnahme der Feldgeräte. Die von den Feldgeräten, insbesondere von Sensoren, erfassten Messwerte werden über das angeschlossene Bussystem an eine oder gegebenenfalls auch an mehrere übergeordnete Einheit(en) übermittelt. Daneben ist auch eine Datenübertragung von der übergeordneten Einheit über das Bussystem an die Feldgeräte erforderlich; diese dient insbesondere zur Konfigurierung und Parametrierung von Feldgeräten oder zu Diagnosezwecken. Allgemein gesprochen, wird das Feldgerät über das Bussystem von der übergeordneten Einheit her bedient.

Neben einer drahtgebundenen Datenübertragung zwischen den Feldgeräten und der übergeordneten Einheit besteht auch die Möglichkeit einer drahtlosen (wireless) Datenübertragung. Insbesondere in den Bussystemen Profibus®, Foundation® Fieldbus und HART® ist eine drahtlose Datenübertragung über Funk spezifiziert. Ferner sind Funknetzwerke für Sensoren in dem Standard IEEE 802.15.4 näher spezifiziert. Zur Realisierung einer drahtlosen Datenübertragung sind neuere Feldgeräte, insbesondere Sensoren und Aktoren, teilweise als Funk-Feldgeräte ausgebildet. Diese weisen in der Regel eine Funkeinheit und eine Stromquelle als integrale Bestandteile auf. Dabei können die Funkeinheit und die Stromquelle in dem Feldgerät selbst oder in einem dauerhaft an dem Feldgerät angeschlossenen Funkmodul vorgesehen sein. Durch die Stromquelle wird eine autarke Energieversorgung des Feldgerätes ermöglicht.

Daneben besteht die Möglichkeit, Feldgeräte ohne Funkeinheiten - also die installierte Basis - durch die Kopplung mit jeweils einem Wireless Adapter, der eine Funkeinheit aufweist, zu einem Funk-Feldgerät aufzurüsten. Ein entsprechender Wireless Adapter ist beispielsweise in der Druckschrift WO 2005/103851 A1 beschrieben. Der Wireless Adapter wird in der Regel an eine Feldbus-Kommunikationsschnittstelle des Feldgerätes lösbar angeschlossen. Über die Feldbus-Kommunikationsschnittstelle kann das Feldgerät die über das Bussystem zu übermittelnden Daten an den Wireless Adapter senden, der diese dann über Funk an den Zielort übermittelt. Umgekehrt kann der Wireless Adapter über Funk Daten empfangen und über die Feldbus-Kommunikationsschnittstelle an das Feldgerät weiterleiten. Die Versorgung des Feldgeräts mit elektrischer Leistung erfolgt dann in der Regel über eine Energieversorgungseinheit des Wireless Adapters.

Bei autarken Funk-Feldgeräten und Wireless Adaptern wird die Kommunikation, beispielsweise mit einer übergeordneten Einheit, in der Regel über die drahtlose Schnittstelle des Funk-Feldgerätes bzw. des Wireless Adapters abgewickelt. Zusätzlich weisen solche Funk-Feldgeräte bzw. Wireless Adapter in der Regel eine drahtgebundene Kommunikationsschnittstelle auf. Beispielsweise ist in dem HART®-Standard vorgesehen, dass Funk-Feldgeräte neben einer drahtlosen Schnittstelle auch eine drahtgebundene Kommunikationsschnittstelle aufweisen müssen. Über solch eine drahtgebundene Kommunikationsschnittstelle ist beispielsweise vor Ort eine Konfiguration des Funk-Feldgerätes bzw. des Wireless Adapters über eine Service- und/oder Bedieneinheit, wie beispielsweise einen Handheld Communicator, die/der an der drahtgebundenen Kommunikationsschnittstelle angeschlossen wird, möglich. Ferner kann die drahtgebundene Kommunikationsschnittstelle als Feldbus-Kommunikationsschnittstelle ausgebildet sein, so dass die Kommunikation darüber entsprechend einem Bussystem, wie beispielsweise entsprechend einem der standardisierten Bussysteme Profibus®, Foundation® Fieldbus oder HART®, abgewickelt wird. Über solch eine Feldbus-Kommunikationsschnittstelle kann das Funk-Feldgerät bzw. der Wireless Adapter auch an einen entsprechenden drahtgebundenen Feldbus angeschlossen werden.

Die Energieversorgungseinheit bzw. die Stromquelle eines Wireless Adapters oder eines Funk-Feldgerätes ist üblicher Weise eine Batterie. Der Ladezustand von Batterien wird im Stand der Technik über eine Verbrauchsmessung, die mittels eines Coulomb-Zählers durchgeführt wird, bestimmt. Ein entsprechendes Verfahren ist beispielsweise in der US-PS 4,488,440 oder in der US 5 372 898 beschrieben. Bekannt ist es auch zur Überwachung einer Batterie eine sog. End-of-life (EOL)-Detektion durchzuführen. Entsprechende Komponenten sind auf dem Markt erhältlich. Weiterer Stand der Technik ist aus US 2005070073 und US 2004090207 bekannt.

Nachteilig bei der Bestimmung der verbleibenden Standzeit der Batterie aus der Verbrauchsmessung ist die relativ große Ungenauigkeit. Dies ist insbesondere dann der Fall, wenn der Ladezustand der Batterie zu Beginn des Einsatzes nicht exakt bekannt ist - ein Problem, das sich beispielsweise bei einer zuvor bereits gebrauchten Batterie oder aufgrund der unterschiedlichen Ladezustände, die auch bei ungebrauchten Batterien auftreten, zeigt.

Das Problem bei der EOL-Detektion ist darin zu sehen, dass bei Batterien mit einer flachen Kennlinie (U / t) keine zuverlässige Vorhersage der Reststandzeit möglich ist. Zudem wird die Batterie durch die EOL-Detektion zusätzlich belastet.

Der Erfindung liegt die Aufgabe zugrunde, eine zuverlässige Bestimmung der Reststandzeit einer Batterie zu ermöglichen, die zur Energieversorgung eines autarken Feldgeräts oder eines Funkadapters in der Automatisierungstechnik verwendet wird.

Die Aufgabe wird dadurch gelöst, dass der aktuelle Leistungsverbrauch der Batterie ermittelt wird, dass während einer ersten Lebensphase der im Betrieb des Feldgeräts ermittelte Leistungsverbrauch der Batterie mit einem vorgegebenen Schwellwert verglichen wird (Coulomb Verfahren), dass bei Überschreiten des vorgegebenen Schwellwerts die Batterie während einer zweiten Lebensphase in vorgegebenen Zeitabständen mit definierten Lastspitzen beaufschlagt wird (End of Life Verfahren / EOL Verfahren), dass die den definierten Lastspitzen entsprechenden Spannungseinbrüche detektiert werden und dass eine Warnmeldung generiert wird, wenn die Spannungseinbrüche einen vorgegebenen maximalen Grenzwert erreichen. Hierdurch hat der Kunde ausreichend Zeit, um die Batterie zu wechseln. Es wird somit sowohl eine Verbrauchskalkulation als auch eine EOL-Detektion verwendet. Hierbei werden die äußeren Einflüsse, wie z.B. der Temperatureinfluss, die eine Rückwirkung auf die Standzeit der Batterie haben, automatisch berücksichtigt. Da die EOL-Detektion erst dann einsetzt, wenn eine definierte Verbrauchsschwelle überschritten ist, wird die zusätzliche Belastung der Batterie erheblich reduziert. Aufgrund der Erfindung ist es möglich, dass ein Batteriewechsel rechtzeitig und geplant erfolgen kann. Somit ist jederzeit der zuverlässige Betrieb eines Batterieversorgten Feldgeräts sichergestellt. Bevorzugt wird in Verbindung mit der Erfindung eine Lithium Batterie verwendet. Lithium Batterien zeichnen sich dadurch aus, dass hier die Spannung während der Entladung relativ konstant bleibt. Typischerweise ist die Entladekurve näherungsweise rechteckig. Mit der Coulomb Counting Methode lassen sich daher keinerlei Aussagen über den Entladezustand der Batterie treffen. Auch ist es kaum möglich mit der Coulomb Counting Methode zu jeder Zeit die nach verfügbare Kapazität der Batterie und damit deren Lebensdauer zuverlässig vorauszusagen (->Lifetime Estimation), was dadurch erschwert wird, dass sich die Umgebungsbedingungen, z.B. die Temperatur, sehr schnell ändern können.

Erfindungsgemäß wird das Coulomb Verfahren dazu verwendet, den richtigen Zeitpunkt für das End of Life Verfahren durch Spannungsüberwachung mit Hilfe von gezielten Spannungsspitzen bzw. Stromstößen zu ermitteln. Im Gegenzug kann das End of Life Verfahren verwendet werden, um die Lifetime Estimation des Coulomb Verfahrens zu prüfen. Bei unvorhergesehenen Temperatureinbrüchen ergibt die Lifetime Estimation zunächst keine zuverlässigen Werte mehr, werden nun definierte Lastspitzen geschaltet, so lässt sich überprüfen, ob die Batterie für den jeweiligen Temperaturbereich noch ausreichend Kapazität hat oder ob der weitere Betrieb gefährdet ist. Im letzt genannten Fall wird eine Meldung an den Kunden abgesetzt. Bevorzugt liegt der Schwellwert für das Umschalten von dem ersten Verfahren auf das zweite Verfahren bei der halben Batterieladung. Es versteht sich von selbst, dass der Schwellwert auch ober- oder unterhalb dieses Wertes angesiedelt sein kann.

Erfindungsgemäß wird das versucht, sich dem tatsächlichen Lebensende sukzessive zu nähern, da erst zum Ende der Lebenszeit anhand der Reaktion auf die Spannungsspitzen verlässliche Rückschlüsse auf den Spannungszustand gezogen werden können.

Weiterhin ist vorgesehen, dass die beiden Verfahren, das Coulomb Verfahren und das End of Life Verfahren, dazu verwendet werden, um sich gegenseitig während der Standzeit/Laufzeit auf Plausibilität hin zu überprüfen.

Um die Standzeit der Batterie zu erhöhen, wird die Belastung dadurch reduziert, dass das Feldgerät und ggf. der Funkadapter, die von der Batterie gespeist werden, intermittierend zwischen Betriebsphasen und Ruhephasen betrieben werden.

Gemäß einer ersten Ausgestaltung des erfindungsgemäßen Verfahrens wird während des Betriebs des Feldgeräts der von der Batterie zur Verfügung gestellte Strom ermittelt und über die Zeit aufintegriert; anschließend wird anhand der ermittelten Werte der Leistungsverbrauch des Feldgeräts bzw. die verbleibende Leistungskapazität der Batterie ermittelt.

Alternativ wird vorgeschlagen, dass während der Betriebsphasen unterschiedliche Betriebszustände des Feldgeräts angesteuert werden und dass jedem Betriebszustand des Feldgeräts ein definierter Leistungsverbrauch der Batterie oder eines Batterietyps zugeordnet wird. Beispielsweise wird der jeweilige Leistungsverbrauch der unterschiedlichen Betriebszustände der Batterie oder des Batterietyps empirisch ermittelt oder berechnet.

Weiterhin ist gemäß einer vorteilhaften Ausgestaltung des erfindungsgemäßen Verfahrens vorgesehen, dass der Leistungsverbrauch der Batterie bzw. des jeweiligen Batterietyps in Abhängigkeit von den auftretenden Betriebszuständen abgespeichert oder in der Betriebsphase ermittelt wird, und dass das Erreichen des vorgegebenen Schwellwertes signalisiert wird, wenn die Summe des Leistungsverbrauchs der aufgetretenen Betriebszuständen den oberen Schwellwert erreicht bzw. überschreitet.

Darüber hinaus wird vorgeschlagen, dass der obere Schwellwert signalisiert wird, wenn die Leistungskapazität der Batterie um zumindest die Hälfte der im ungebrauchten Zustand der Batterie zur Verfügung stehenden Leistungskapazität zurückgegangen ist. Es versteht sich von selbst, dass auch anderweitige Bruchteile der Leistungskapazität im Zusammenhang mit dem erfindungsgemäßen Verfahren Anwendung finden können.

Eine weitere Alternative sieht vor, dass der über die Lebensdauer gespeicherte Gesamtverbrauch der Batterie oder des Batterietyps in Abhängigkeit von den am Einsatzort der Batterie herrschenden Prozessbedingungen abgespeichert wird.

Als besonders vorteilhaft wird es im Zusammenhang mit der Erfindung angesehen, wenn in Abhängigkeit von der ermittelten Lebensdauer der Batterie unter den am Einsatzort herrschenden Prozessbedingungen ein optimierter Schwellwert ermittelt wird.

Gemäß einer vorteilhaften Ausgestaltung des erfindungsgemäßen Verfahrens lässt sich ein Bench Marking betreiben: der Gesamtverbrauch am Lebensende der Batterie wird für die Berechnung der Restlaufzeit und der Optimierung des Schwellwertes beim Einsatz der nachfolgenden Batterie des gleichen Typs verwendet. Ursprünglich verwendete Schwellwerte können infolge dieses Selbstlernmechanismus' durch Erfahrungswerte aus vergangenen Zeitperioden korrigiert werden. Da die Schwellwerte gelernt werden, wird eine Vorrichtung, bei der das erfindungsgemäße Verfahren zum Einsatz kommt, umso verlässlichere Aussagen ermöglichen, je länger die Vorrichtung im Betrieb ist.

Eine bevorzugte Weiterbildung des erfindungsgemäßen Verfahrens schlägt vor, dass die Zeitabstände, in denen die Batterie mit definierten Überlastspitzen beaufschlagt wird, variiert werden.

Additiv oder alternativ ist vorgesehen, dass die Höhe der Überlastspitzen in Abhängigkeit von dem jeweiligen Leistungszustand der Batterie variiert wird. Hierdurch wird die Belastung der Batterie gleichfalls verringert.

Weiterhin wird vorgeschlagen, dass aus der Differenz des aktuellen Leistungsverbrauchs und der Leistungskapazität der Batterie eine Restlaufzeit für den Betrieb des Feldgerätes unter Berücksichtigung der jeweiligen Betriebszustände des Feldgerätes bestimmt wird.

Die Erfindung wird anhand der nachfolgenden Figuren näher erläutert. Es zeigt:
- Fig. 1:: eine schematische Darstellung eines Funknetzwerkes mit mehreren Feldgeräten,
- Fig. 2:: ein Blockschaltbild eines Feldgerätes und eines angeschlossenen Wireless Adapters und
- Fig. 3:: eine typische Entladekurve einer Batterie, wobei eine spezielle Ausgestaltung des erfindungsgemäßen Verfahrens anhand der Entladekurve darstellt ist.

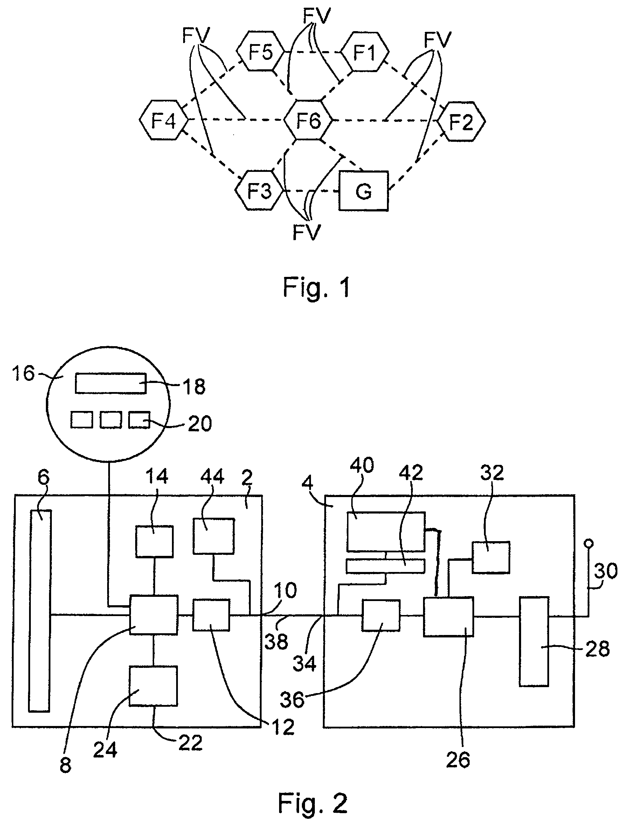

In Fig. 1 ist ein Funknetzwerk mit mehreren Feldgeräten F1, F2, ..., F6, die jeweils als Funk-Feldgeräte ausgebildet sind, und einem Gateway G dargestellt. Die Feldgeräte F1, F2, ..., F6 stehen untereinander und mit dem Gateway G in Funkverbindung FV, was in Fig. 1 durch die gestrichelten Linien dargestellt ist. Da die Feldgeräte F1, F2, ..., F6 und das Gateway G jeweils über mehrere Funkverbindungen FV untereinander kommunizieren können, bleibt auch beim Ausfall einer der Funkverbindungen FV die Kommunikation über eine der anderen Funkverbindungen FV aufrechterhalten. Als Funkübertragungstechnologien für die Funkverbindungen FV sind beispielsweise Frequency Hopping Spread Spectrum (FHSS) oder Direct Sequence Spread Spectrum (DSSS) Verfahren geeignet. Aufgrund der benötigten geringen Sendeleistungen ist auch die Ultrawideband-Technologie (UWB) sehr gut geeignet. Bei dem Gateway G kann es sich um eine Fernübertragungseinheit, z.B. das Produkt "Fieldgate" der Firma Endress + Hauser, handeln. In diesem Fall kann das Gateway G weltweit zum Beispiel via Internet, GSM oder Festnetz mit einer übergeordneten Einheit kommunizieren. Ferner kann/können eine (nicht dargestellte) übergeordnete Einheit und/oder ein (nicht dargestelltes) Bediengerät auch direkt über eine entsprechende Funkverbindung mit dem dargestellten Funknetzwerk kommunizieren.

In dem Blockschaltbild der Fig. 2 sind ein herkömmlich ausgebildetes Feldgerät 2 und ein daran angeschlossener Wireless Adapter 4 schematisch dargestellt. Durch Anschluss des Wireless Adapters 4 kann das Feldgerät 2 zu einem Funk-Feldgerät, wie es beispielsweise in Fig. 1 durch die Feldgeräte F1, F2, ... F6 dargestellt ist, aufgerüstet werden. Das Feldgerät 2 weist einen Messwertaufnehmer 6 und eine Steuereinheit, die als Mikroprozessor 8 ausgebildet ist, auf. Der Messwertaufnehmer 6 und der Mikroprozessor 8 stehen miteinander in Kommunikationsverbindung. Ferner weist das Feldgerät 2 eine mit dem Mikroprozessor 8 in Verbindung stehende drahtgebundene HART®-Kommunikationsschnittstelle 10, die beispielsweise dem HART®-Standard entspricht. Der HART®-Kommunikationsschnittstelle 10 ist eine Funktionseinheit 12 zugeordnet, die durch einen ASIC (engl.: applikation specific integrated circuit; deutsch: anwendungsspezifische integrierte Schaltung) gebildet wird und die das Senden und/oder Empfangen von digitalen Signalen (entsprechend dem HART®-Standard) über die HART®-Kommunikationsschnittstelle 10 durchführt. Über die HART®-Kommunikationsschnittstelle 10 könnte das Feldgerät 2 alternativ zu dem dargestellten Anschluss an den Wireless Adapter 4 an ein drahtgebundenes HART®-Feldbussystem angeschlossen werden.

Ferner weist das Feldgerät 2 einen Datenspeicher 14 auf, in dem unter anderem Parameter des Feldgerätes 2 abgelegt sind. Ein Zugriff auf den Datenspeicher 14 erfolgt über den Mikroprozessor 8. Für eine Bedienung des Feldgerätes 2 vor Ort ist an dem Feldgerät 2 eine Anzeige- und Bedieneinheit 16 vorgesehen, die eine Anzeigeeinheit 18 und eine Bedieneinheit 20 in Form eines Tastenfeldes aufweist und in Kommunikationsverbindung mit dem Mikroprozessor 8 steht. Eine Bedienung des Feldgerätes 2 vor Ort kann auch von einem (nicht dargestellten) Bediengerät aus vorgenommen werden. Hierzu ist an dem Feldgerät 2 ferner eine Service-Schnittstelle 22, die in Kommunikationsverbindung mit dem Mikroprozessor 8 steht, vorgesehen. Die Kommunikation über die Service-Schnittstelle 22 ist herstellerspezifisch, d.h. sie erfolgt nicht gemäß einem standardisierten Feldbus-Protokoll. Der Service-Schnittstelle 22 ist wiederum eine Funktionseinheit 24 in Form eines ASIC zugeordnet, durch den das Senden und/oder Empfangen von digitalen Signalen (entsprechend der herstellerspezifischen Kommunikation) über die Service-Schnittstelle 22 durchgeführt wird.

Der Wireless Adapter 4 weist ebenfalls eine Steuereinheit in Form eines Mikroprozessors 26 auf. Zum Datenaustausch über das Funk-Netzwerk ist der Mikroprozessor 26 mit einer Funkeinheit 28 verbunden, die ein RF-Chipset und eine Antenne 30 aufweist. Die Funkeinheit 28 ist dabei derart ausgebildet, dass die drahtlose Kommunikation gemäß dem HART®-Standard erfolgt. Der Mikroprozessor 26 ist ferner mit einem Datenspeicher 32 verbunden, in dem unter anderem Parameter des Wireless Adapters 4 abgelegt sind. Zur Kommunikation mit dem Feldgerät 2 weist der Wireless Adapter 4 eine drahtgebundene HART®-Kommunikationsschnittstelle 34 auf, der wiederum eine Funktionseinheit 36, die das Senden und/oder Empfangen von digitalen Signalen über die HART®-Kommunikationsschnittstelle 34 (gemäß dem HART®-Standard) durchführt, zugeordnet ist. Die Funktionseinheit 36 wird dabei wiederum durch einen ASIC gebildet. Bei der in Fig. 2 dargestellten Anordnung werden die HART®-Kommunikationsschnittstelle 10 des Feldgerätes 2 und die HART®-Kommunikationsschnittstelle 34 des Wireless Adapters 4 über eine 2-Leiter-Verbindungsleitung 38 miteinander verbunden. Über diese Verbindung erfolgt sowohl die Kommunikation zwischen dem Feldgerät 2 und dem Wireless Adapter 4 als auch die Stromversorgung des Feldgerätes 2 durch den Wireless Adapter 4.

Zur Bereitstellung der Stromversorgung des Feldgerätes 2 (und des Wireless Adapters 4) weist der Wireless Adapter 4 eine Stromquelle in Form einer Batterie 40 und ein an der Batterie 40 angeschlossener Spannungswandler 42 auf. Über den Spannungswandler 42 werden die Systemkomponenten des Wireless Adapters 4 (über nicht dargestellte Stromversorgungsleitungen) sowie die System-komponenten des Feldgerätes 2 über die HART®-Kommunikationsschnittstelle 34, die 2-Leiter-Verbindungsleitung 38, die HART®-Kommunikations-schnittstelle 10 und ein daran angeschlossener ,Spannungswandler 44 des Feldgerätes 2 mit elektrischer Leistung versorgt.

Die Überwachung der Batterie 40 entsprechend dem erfindungsgemäßen Verfahren erfolgt über den Mikroprozessor 26.

Obwohl in der Zeichnung ein Feldgerät 2 dargestellt ist, das über einen Funkadapter 4 zu einem autarken Funk-Feldgerät aufgerüstet ist, versteht es sich von selbst, dass das erfindungsgemäße Verfahren zur Erkennung des Ladezustands der Batterie 40 auch bei einem autarken Feldgerät 2 verwendet werden kann. Hier sind die Batterie 40, das Funkmodul 28 und die Antenne 30 direkt in das Feldgerät 2 integriert.

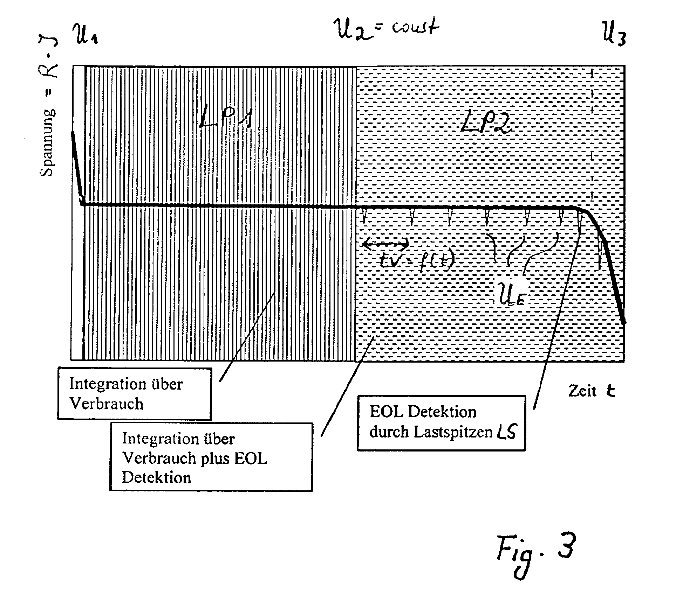

In Fig. 3 ist ein typische Entladekurve einer Batterie 40 dargestellt. Zu Beginn ihrer Lebenszeit liefert die Batterie 40 eine hohe Spannung U1(t), die sich nach relativ kurzer Zeit auf einen zumindest näherungsweise konstanten Wert U2 (t) = const. einpendelt. Den Großteil ihrer Lebenszeit liefert die Batterie 40 die konstante Spannung U2. Gegen Ende der Standzeit fällt die Spannung U3(t) der Batterie 40 relativ schnell ab, so dass die Batterie 40 bei Unterschreiten einer vorgegebenen minimalen Spannung als Energiequelle gänzlich ausfällt. Da ein plötzlicher Ausfall der Batterie zum Ausfall des Feldgeräts 2 und gegebenenfalls zum Stillstand der Prozessanlage führt, in die das Feldgerät 2 integriert ist, muss frühzeitig ein Hinweis geliefert werden, der das Ende der Lebenszeit bzw. Standzeit der Batterie 40 anzeigt.

In Fig.3 ist zusätzlich zu der typischen Entladekurve U(t) der Batterie 40 eine bevorzugte Ausgestaltung des erfindungsgemäßen Verfahrens dargestellt. Erfindungsgemäß wird in unterschiedlichen Bereichen der Entladekurve U(t) die Anwendung unterschiedlicher Maßnahmen zur Erkennung des jeweiligen Entladezustands der Batterie 40 vorgeschlagen. Insbesondere wird über die Lebenszeit der Batterie in gewissen Zeitabständen jeweils der aktuelle Leistungsverbrauch der Batterie 40 ermittelt. Während der ersten Lebensphase LP1 wird der im Betrieb des Feldgeräts 2 ermittelte Leistungsverbrauch der Batterie 40 mit einem vorgegebenen Schwellwert verglichen. Sobald dieser vorgegebene Schwellwert der Batterie 40 überschritten wird, tritt die Batterie 40 in ihre zweite Lebensphase LP2. Während dieser zweiten Lebensphase LP2 wird die Batterie 40 von dem Mikroprozessor 26 aus in vorgegebenen Zeitabständen tv mit definierten Lastspitzen beaufschlagt. Die den definierten Lastspitzen entsprechenden Spannungseinbrüche UE der Batterie 40 werden detektiert. Eine Warnmeldung wird generiert, wenn die Spannungseinbrüche UE einen vorgegebenen maximalen Grenzwert erreichen. Die Warnmeldung führt nachfolgend z.B. zu einer Darstellung auf der Anzeigeeinheit 18, oder es erfolgt eine Übermittlung an die übergeordnete Steuereinheit.

Bevorzugt wird während des Betriebs des Feldgeräts 2 der von der Batterie 40 zur Verfügung gestellte Strom I ermittelt und über die Zeit t aufintegriert. Anhand der ermittelten Werte wird anschließend der Leistungsverbrauch des Feldgeräts 2 bzw. die verbleibende Leistungskapazität der Batterie 40 ermittelt.

Alternativ werden während der Betriebsphasen unterschiedliche Betriebszustände des Feldgeräts 2 angesteuert, wobei jedem Betriebszustand des Feldgeräts 2 ein definierter Leistungsverbrauch der Batterie 40 oder eines Batterietyps zugeordnet wird. Ein typischer Vorgang ist hier die Inbetriebnahme des Feldgeräts 2, seine Parametrierung und die Messwertabfrage. Beispielsweise kann der jeweilige Leistungsverbrauch der unterschiedlichen Betriebszustände der Batterie 40 oder des Batterietyps empirisch ermittelt und berechnet werden.

Auch ist es vorteilhaft, den Leistungsverbrauch der Batterie 40 bzw. des jeweiligen Batterietyps in Abhängigkeit von den auftretenden Betriebszuständen abzuspeichern bzw. in den Betriebsphasen zu ermitteln, wobei das Erreichen des vorgegebenen Schwellwertes signalisiert wird, wenn die Summe des Leistungsverbrauchs der aufgetretenen Betriebszuständen den oberen Schwellwert erreicht bzw. überschreitet. Beispielsweise wird das Erreichen des oberen Schwellwerts signalisiert, wenn die Leistungskapazität der Batterie um zumindest die Hälfte der im ungebrauchten Zustand der Batterie 40 zur Verfügung stehenden Leistungskapazität zurückgegangen ist.

Zwecks Energieeinsparung und - damit einher gehend - zwecks Erhöhung der Standzeit der Batterie 40 werden in der zweiten Lebensphase die Zeitabstände, in denen die Batterie 40 mit definierten Überlastspitzen beaufschlagt wird, variiert. So nimmt der Abstand, in dem die Überlastspitzen auf die Batterie 40 gegeben werden, z.B. vom Beginn zum Ende der zweiten Lebensphase LP2 hin ab. Weiterhin ist vorgesehen, dass die Höhe der Überlastspitzen in Abhängigkeit vom Leistungszustand der Batterie 40 variiert wird.

## Patentansprüche

1. Verfahren zur Überwachung der Reststandzeit einer Batterie (40),
wobei
der aktuelle Leistungsverbrauch der Batterie (40) ermittelt wird, und während einer ersten Lebensphase (LP1) der im Betrieb des Feldgeräts (2) ermittelte Leistungsverbrauch der Batterie (40) mit einem vorgegebenen Schwellwert verglichen wird, **dadurch gekennzeichnet, daß** die Batterie zum Betreiben eines Feldgeräts (2) in der Automatisierungstechnik verwendet wird, dass bei Überschreiten des vorgegebenen Schwellwerts die Batterie (40) während einer zweiten Lebensphase (LP2) in vorgegebenen Zeitabständen (tv) mit definierten Lastspitzen (LS) beaufschlagt wird,
dass die den definierten Lastspitzen (LS) entsprechenden Spannungseinbrüche detektiert werden und
dass eine Warnmeldung generiert wird, wenn die Spannungseinbrüche einen vorgegebenen maximalen Grenzwert erreichen.

2. Verfahren nach Anspruch 1,
**dadurch gekennzeichnet,**
**dass** das Feldgerät (2) intermittierend zwischen Betriebsphasen und Ruhephasen betrieben wird.

3. Verfahren nach Anspruch 1 oder 2,
**dadurch gekennzeichnet,**
**dass** während des Betriebs des Feldgeräts (2) der von der Batterie (40) zur Verfügung gestellte Strom (I) ermittelt und über die Zeit (t) aufintegriert wird
und
**dass** anhand der ermittelten Werte der Leistungsverbrauch des Feldgeräts (2) bzw. die verbleibende Leistungskapazität der Batterie (40) ermittelt wird.

4. Verfahren nach Anspruch 1 oder 2,
**dadurch gekennzeichnet,**
**dass** während der Betriebsphasen unterschiedliche Betriebszustände des Feldgeräts (2) angesteuert werden und
**dass** jedem Betriebszustand des Feldgeräts (2) ein definierter Leistungsverbrauch der Batterie (40) oder eines Batterietyps zugeordnet wird.

5. Verfahren nach Anspruch 4,
**dadurch gekennzeichnet,**
**dass** der jeweilige Leistungsverbrauch der unterschiedlichen Betriebszustände der Batterie (40) oder des Batterietyps empirisch ermittelt oder berechnet wird.

6. Verfahren nach Anspruch 2, 4 oder 5,
**dadurch gekennzeichnet,**
**dass** der Leistungsverbrauch der Batterie (40) bzw. des jeweiligen Batterietyps in Abhängigkeit von den auftretenden Betriebszuständen abgespeichert oder in der Betriebsphase ermittelt wird, und
**dass** das Erreichen des vorgegebenen Schwellwertes signalisiert wird, wenn die Summe des Leistungsverbrauchs der aufgetretenen Betriebszuständen den oberen Schwellwert erreicht bzw. überschreitet.

7. Verfahren nach Anspruch 1,
**dadurch gekennzeichnet,**
**dass** der obere Schwellwert signalisiert wird, wenn die Leistungskapazität der Batterie um zumindest die Hälfte der im ungebrauchten Zustand der Batterie (40) zur Verfügung stehenden Leistungskapazität zurückgegangen ist.

8. Verfahren nach einem oder mehreren der vorhergehenden Ansprüche,
**dadurch gekennzeichnet,**
**dass** der über die Lebensdauer gespeicherte Gesamtverbrauch der Batterie oder des Batterietyps in Abhängigkeit von den am Einsatzort der Batterie herrschenden Prozessbedingungen abgespeichert wird.

9. Verfahren nach Anspruch 8,
**dadurch gekennzeichnet,**
**dass** in Abhängigkeit von der ermittelten Lebensdauer der Batterie (40) unter den am Einsatzort herrschenden Prozessbedingungen ein optimierter Schwellwert ermittelt wird.

10. Verfahren nach Anspruch 9,
**dadurch gekennzeichnet,**
**dass** der Gesamt-Leistungsverbrauch am Lebensende der Batterie (40) für die Berechnung der Restlaufzeit und der Optimierung des Schwellwertes beim Einsatz der nachfolgenden Batterie (40) des gleichen Typs verwendet wird.

11. Verfahren nach Anspruch 1,
**dadurch gekennzeichnet,**
**dass** die Zeitabstände, in denen die Batterie (40) mit definierten Überlastspitzen beaufschlagt wird, variiert wird.

12. Verfahren nach Anspruch 1,
**dadurch gekennzeichnet,**
**dass** die Höhe der Überlastspitzen abhängig vom Leistungszustand der Batterie (40) variiert wird.

13. Verfahren nach einem der vorherigen Ansprüche,
**dadurch gekennzeichnet,**
**dass** aus der Differenz des aktuellen Leistungsverbrauchs und der Kapazität der Batterie eine Restlaufzeit für den Betrieb des Feldgerätes unter Berücksichtigung der jeweiligen Betriebszustände des Feldgerätes bestimmt wird.

## Claims

1. Method to monitor the remaining service life of a battery (40), wherein
the current power consumption of the battery (40) is determined and, during a first life phase (LP1), the power consumption of the battery (40) determined during the operation of the field device is compared against a predefined threshold value,
**characterized in that**
the battery is used to operate a field device (2) in automation engineering,
if the predefined threshold value is exceeded, the battery (40) is exposed to defined load peaks (LS) at predefined intervals (tv) during a second life phase (LP2) the voltage dips corresponding to the defined load peaks (LS) are detected, and
a warning message is generated if the voltage dips reach a predefined maximum limit value.

2. Method as claimed in Claim 1
**characterized in that**
the field device (2) is operated intermittently between operating phases and rest phases.

3. Method as claimed in Claim 1 or 2,
**characterized in that**
the current (I) provided by the battery (40) is determined while the field device (2) is in operation and integrated over time (t)
and
that the power consumption of the field device (2), or the remaining power capacity of the battery (40), is determined on the basis of the values determined.

4. Method as claimed in Claim 1 or 2,
**characterized in that**
different operational states of the field device (2) are commanded during the operational phases and
a defined power consumption of the battery (40) or a battery type is assigned to every operating state of the field device (2).

5. Method as claimed in Claim 4,
**characterized in that**
the specific power consumption of the different operating states of the battery (40) or the battery type is empirically determined or calculated.

6. Method as claimed in Claim 2, 4 or 5
**characterized in that**
the power consumption of the battery (40) or of the particular battery type is saved depending on the operating states that occur, or determined in the operating phase, and the arrival at the predefined threshold value is signaled if the sum of the power consumption of the operating states that occurred reaches or exceeds the upper threshold value.

7. Method as claimed in Claim 1,
**characterized in that**
the upper threshold value is signaled when the power capacity of the battery has dropped by at least half the power capacity that is available in the unused state of the battery (40).

8. Method as claimed in one or more of the previous claims,
**characterized in that**
the total consumption of the battery or battery type which is saved over the lifetime is stored depending on the process conditions present at the place of use of the battery.

9. Method as claimed in Claim 8,
**characterized in that**
an optimized threshold value is determined depending on the determined lifetime of the battery (40) under the process conditions present at the place of use.

10. Method as claimed in Claim 9,
**characterized in that**
the total power consumption at the end of the battery life (40) is used to calculate the remaining service life and to optimize the threshold value when using a subsequent battery (40) of the same type.

11. Method as claimed in Claim 1,
**characterized in that**
the intervals at which the battery (40) is exposed to defined overload peaks vary.

12. Method as claimed in Claim 1,
**characterized in that**
the level of the overload peaks varies depending on the state of function of the battery (40).

13. Method as claimed in one of the previous claims,
**characterized in that**
a remaining service life for the operation of the field device is determined from the difference of the current power consumption and the capacity of the battery, while taking the particular operating states of the field device into consideration.

## Revendications

1. Procédé destiné à la surveillance de la durée de vie restante d'une batterie (40), pour lequel la consommation d'énergie actuelle de la batterie (40) est déterminée et, pendant une première phase de vie (LP1), la consommation d'énergie de la batterie (40) déterminée pendant le fonctionnement de l'appareil de terrain est comparée avec une valeur seuil prédéfinie, **caractérisé en ce que** la batterie est utilisée pour l'exploitation d'un appareil de terrain (2) de la technique d'automatisation, **en ce qu'**en cas de dépassement de la valeur seuil prédéfinie, la batterie (40) est soumise pendant une deuxième phase de vie (LP2), à des pointes de charge (LS) à intervalles de temps réguliers (tv),
**en ce que** sont détectées les chutes de tension correspondant aux pointes de charge (LS) définies et
**en ce qu'**est généré un message d'avertissement lorsque les chutes de tension atteignent un seuil maximal prédéfini.

2. Procédé selon la revendication 1,
**caractérisé en ce**
**que** l'appareil de terrain (2) est utilisé de façon intermittente entre des phases de fonctionnement et des phases de repos.

3. Procédé selon la revendication 1 ou 2,
**caractérisé en ce**
**que** pendant le fonctionnement de l'appareil de terrain (2) est déterminé et intégré dans le temps (t) le courant (I) mis à disposition par la batterie (40) et
en ce qu'est déterminée, au moyen des valeurs déterminées, la consommation d'énergie de l'appareil de terrain (2) ou la capacité de puissance restante de la batterie (40).

4. Procédé selon la revendication 1 ou 2,
**caractérisé en ce**
**que**, pendant les phases de fonctionnement, différents états de fonctionnement de l'appareil de terrain (2) sont commandés et
en ce qu'à chaque état de fonctionnement de l'appareil de terrain (2) est attribuée une consommation d'énergie définie de la batterie (40) ou d'un type de batterie.

5. Procédé selon la revendication 4,
**caractérisé en ce**
**qu'**est déterminée de façon empirique ou calculée la consommation d'énergie respective pour les différents états de fonctionnement de la batterie (40) ou du type de batterie.

6. Procédé selon la revendication 2, 4 ou 5,
**caractérisé en ce**
**qu'**est enregistrée ou déterminée dans la phase de fonctionnement la consommation d'énergie de la batterie (40) ou du type de batterie respectif en fonction des états de fonctionnement survenant, et
en ce qu'est signalée l'atteinte du seuil prédéfini lorsque la somme de la consommation d'énergie des états de fonctionnement survenus atteint ou dépasse le seuil supérieur.

7. Procédé selon la revendication 1,
**caractérisé en ce**
**qu'**est signalé le seuil supérieur lorsque la capacité de puissance de la batterie a décru d'au moins la moitié de la capacité de puissance disponible à l'état inutilisé de la batterie (40).

8. Procédé selon l'une des revendications précédentes,
**caractérisé en ce**
**que** la consommation totale, enregistrée tout au long de la durée de vie, de la batterie ou du type de batterie est enregistrée en fonction des conditions de process régnant sur le lieu d'utilisation de la batterie.

9. Procédé selon la revendication 8,
**caractérisé en ce**
**qu'**est déterminé un seuil optimisé en fonction de la durée de vie déterminée de la batterie (40), dans les conditions de process régnant sur le lieu d'utilisation.

10. Procédé selon la revendication 9,
**caractérisé en ce**
**que** la consommation de puissance totale en fin de vie de la batterie (40) est utilisée pour le calcul de la durée de vie restante et l'optimisation du seuil lors de l'utilisation de la batterie (40) suivante de même type.

11. Procédé selon la revendication 1,
**caractérisé en ce**
**que** sont variés les intervalles de temps, pendant lesquels la batterie (40) est soumise à des pointes de surcharge définies.

12. Procédé selon la revendication 1,
**caractérisé en ce**
**qu'**est variée l'amplitude des pointes de surcharge en fonction de l'état de performance de la batterie (40).

13. Procédé selon l'une des revendications précédentes,
**caractérisé en ce**
**qu'**est déterminée, à partir de la différence de la consommation d'énergie actuelle et de la capacité de la batterie, une durée de vie restante pour le fonctionnement de l'appareil de terrain, en considérant les différents états de fonctionnement de l'appareil de terrain.
